# EUROPEAN PATENT APPLICATION

(11) **EP 4 181 009 A1**
(43) Date of publication of application: **17.05.2023**
(21) Application number: 21383019.3
(22) Date of filing: 11.11.2021
(51) Int. Cl.: G06F 30/15, G01B 11/25, G01B 11/14, B64C 9/16

(54) **COMPUTER-IMPLEMENTED METHOD FOR DETERMINING GAPS AND OVERLAPS BETWEEN TWO OR MORE AIRCRAFT REAL PARTS WITH A DEFINED KINEMATIC BEETWEEN THEM**

(71) Applicant: Airbus Defence and Space, S.A.U., 28906 Getafe - Madrid (ES)
(72) Inventor: LEÓN ARÉVALO, Francisco, José, 28906 GETAFE (Madrid) (ES); BLANCO MUÑOZ, Jose, Manuel, 28906 GETAFE (Madrid) (ES)
(74) Representative: ABG Intellectual Property Law, S.L.

(57) **Abstract**

It is provided a reliable and high-precision computer-implemented method to determine the final geometry of two or more aircraft real parts, in particular to predict final measurements even at non-visible or non-measurable gaps (G) and overlaps (O) in said aircraft real parts, and when there is a kinematic between them. Said computer-implemented method comprises the following steps: obtaining digital data by independently scanning all the aircraft real parts; creating a digital twin model from the obtained digital data, performing a virtual assembly of the aircraft digital parts; and reporting final measurements.

## Description

### OBJECT OF THE INVENTION

The present invention refers to the technical field of aeronautical industry, and more specifically to methods for determining the final geometry of two or more elements.

The object of the present invention is to provide a reliable high-precision computer implemented-method to determine the final geometry of two or more aircraft real parts, in particular to predict final measurements even at non-visible or non-measurable gaps and overlaps in said aircraft real parts, and when there is a kinematic between them.

### BACKGROUND OF THE INVENTION

At present, methods for measuring linear dimensions, angles and irregularities of surfaces or contours are widely known. This is especially relevant in the aerospace sector, where very high precision is required and where every part and every aerostructure must be designed and measured to the millimeter before it is manufactured and final assembled.

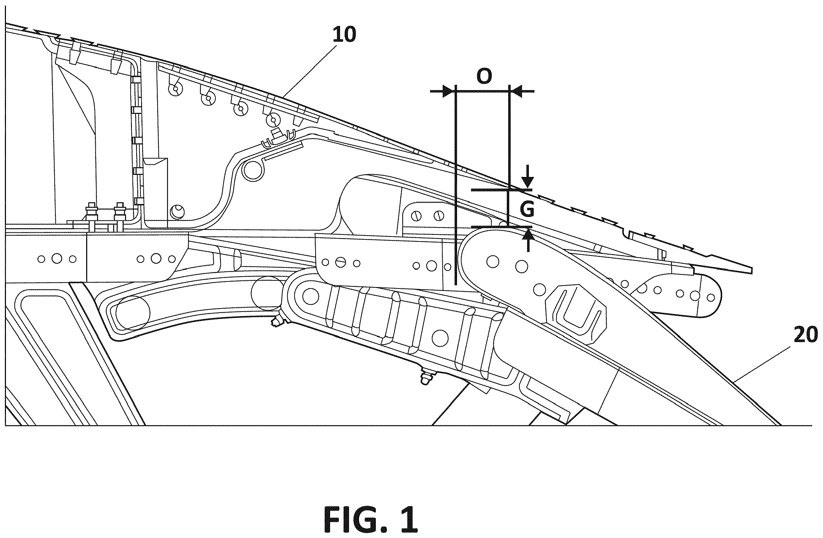

However, after assembly, some design office requirements are not possible to check, for instance in flaps and flap-tabs. The example related at Figure 1 is a real gap (G) and overlap (O) required to be measured. These measurements (gaps and/or overlaps between different parts) are not easy to be done because of no enough space for carry out the measurement, where there are frequent difficulties of access and a very limited space available. Even in the case it could be measured, it not possible to be measured at the full travel, checking the performance during the kinematic movement.

### DESCRIPTION OF THE INVENTION

The present invention solves the above-mentioned drawbacks, providing a reliable and accurate computer-implemented method to predict and determine final measurements in aircraft real parts, even at non- visible or non-measurable gaps and overlaps in said aircraft real parts, and when there is a kinematic between them.

More in particular, the computer-implemented method of the invention comprises the following steps:
- obtaining digital data by independently scanning all the aircraft real parts which comprise gaps (G) and overlaps (O) to be measured, the digital data defining geometries and points of each aircraft real part;
- creating a digital twin model from the obtained digital data, the digital twin model comprising an aircraft digital part for each aircraft real part, the creation of each aircraft digital part of the digital twin model comprising modelling in three dimensions the defined geometries and aligning the defined points for each aircraft real part;
- performing a virtual assembly of the aircraft digital parts applying the kinematics defined for each aircraft real part to obtain at least one set of positions of the gaps (G) and overlaps (O); and
- reporting final measurements calculated for the, at least one, set of positions of the gaps (G) and overlaps (O) in the virtually assembled aircraft digital parts.

Thus, this method makes it possible to measure gaps and overlaps even when the interface related cannot be measured, understanding "interface" as the interaction between the two aircraft real parts between which the gaps and/or overlaps to be measured exist.

As already mentioned, although the gaps and overlaps are not really measurable, their value is known from an indirect measurement based on the previously scanned digital twin model and the measurement of the related points where the gaps and overlaps to be measured are located.

Preferably, in the first step, the scanning of the aircraft real parts is carried out using photogrammetry and structural light pattern (SLP) scanners. In this way, the full surface scanning (point cloud) is linked with photogrammetry scanning (discrete points), thus obtaining a more complete and accurate result at this stage of digitalization.

For its part, in the second step, the alignment of the points for each aircraft real part defined in the digital twin model is carried out using digital mockup (MDU) or real hinge axis of the aircraft real part. In this way, by introducing the photogrammetrically measured skeleton obtained in the first step into the digital twin model of the second step, it is possible to recalculate the entire external surface of the parts to be measured in real time and with high precision.

Furthermore, in said second step, modelling in three dimensions the defined geometries comprises placing all the geometries on a reference. In other words, since the geometries of the parts have been scanned separately, in order to be able to correctly carry out the method of the invention, an alignment is made with respect to the design obtained by computer-aided design (CAD). In this way, once the "real" scanned surfaces are perfectly positioned and aligned with respect to the CAD design, a real 3D model is created with which to continue working.

Referring now to third step of the virtual assembly, once we have reached this step, we have all the necessary information to make a virtual assembly and measure all the data, e.g. gaps and overlaps, in a predictive way. In virtual assembly, the hinge line or kinematics is obtained from the theoretical information of the digital mockup (DMU) and the real measurements of the parts to be measured before assembly. In this phase, the movement of the part related to the kinematics is theoretical.

More specifically, in one of the possible examples, the relative movement of one part with respect to the other is an axis of rotation. In this sense, the above-mentioned hinge line is relevant because the definition of the axis of rotation can be done both "theoretically" where the digital mockup (DMU) indicates, and "practically", taking into account the real axis, if the latter is measurable. The solution proposed here is valid and can be used in both cases.

More specifically, according to a preferred embodiment of the invention, the step of performing the virtual assembly is carried out using digital mockup (DMU) kinematics and/or real kinematics.

Regarding the above, when real kinematics is used, the method further comprises determining the movement of the aircraft digital part by using a re-scanning of photogrammetry points of the aircraft real part in real time. According manufacturing tolerances, this virtual assembly can be enough.

More specifically, preferably the final measurements are calculated according to measured positions of the aircraft real external parts and the calculations of distances between the measured positions of the aircraft real external parts.

Thus, by means of the computer-implemented method described here, through the creation of a digital twin model to virtualize the assembly of the aircraft parts, it is possible to predict and calculate with high accuracy the final measurements of the parts, even when there is kinematics involved between these parts. Furthermore, this method can be used to measure gaps and overlaps between aircraft real parts, solving the problems of access to narrow spaces, and allowing to check the hidden parts of the assembly at different locations and/or different angles of deflection.

### BRIEF DESCRIPTION OF THE DRAWINGS

For a better understanding the above explanation and for the sole purpose of providing an example, some non-limiting drawings are included that schematically depict a practical embodiment.
Figure 1 shows an example of a gap and overlap measurement in an aerostructure, in particular between a flap and its flap-tap.
Figure 2 shows the measurement cycle of the computer-implemented method of the present invention.
Figure 3 shows an aerostructure being scanned, using structured light pattern (SLP).
Figure 4 shows a flap and a flap-tap being scanned, according to first step of the method, obtaining digital data.
Figure 5 shows the photogrammetry skeleton of the parts scanned in the first step.
Figure 6 shows the photogrammetry data obtained in the first step.
Figure 7 shows a digital twin model, in particular the points cloud alignment obtained using digital mockup (DMU), according to second step of the method, creating a digital twin model
Figure 8 shows different positions of the digital twin model of figure 7, in particular the flap kinematic retracted, and full deployed, respectively.
Figure 9 shows the virtual assembly of the flap using digital mockup (DMU) kinematics, according to an alternative of the third step of the method, performing a virtual assembly of the aircraft digital parts.
Figure 10 shows the virtual assembly of the flap-tap using real kinematics, according to another alternative of the third step of the method.

### PREFERRED EMBODIMENT OF THE INVENTION

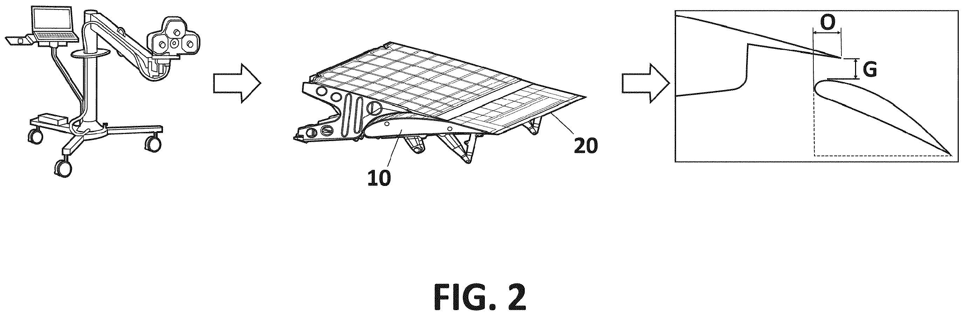

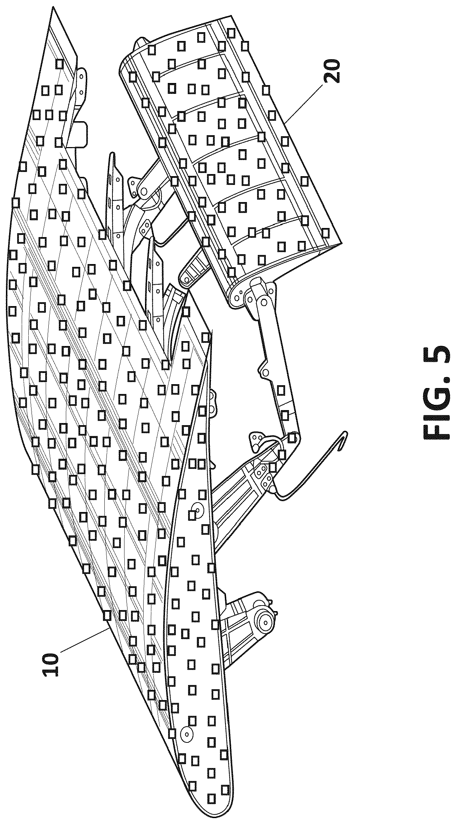

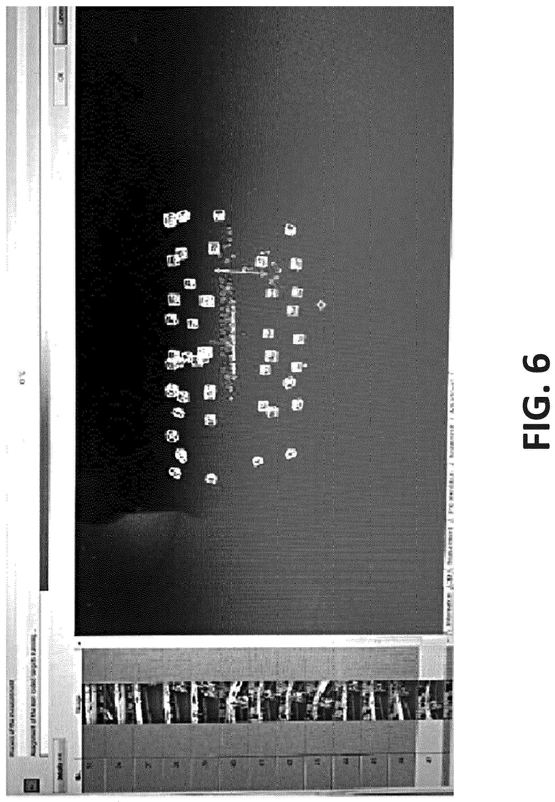

An example of a preferred embodiment is described below, mentioning the figures above, without limiting or reducing the scope of protection of the present invention. According to the present example of the invention, showed in figures 2-10, the computer-implemented method of the invention has been tested on C295 flaps (10) and flap-tabs (20) of an aircraft. However, this method could be extrapolated to other aerostructures assemblies.

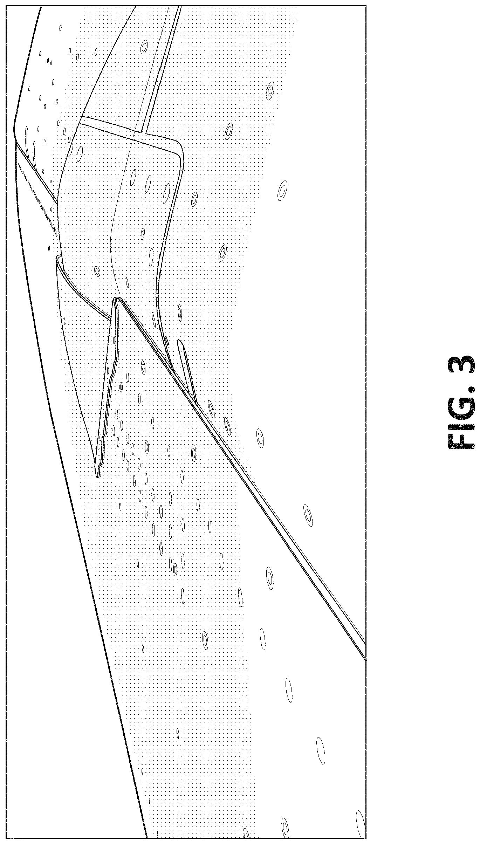

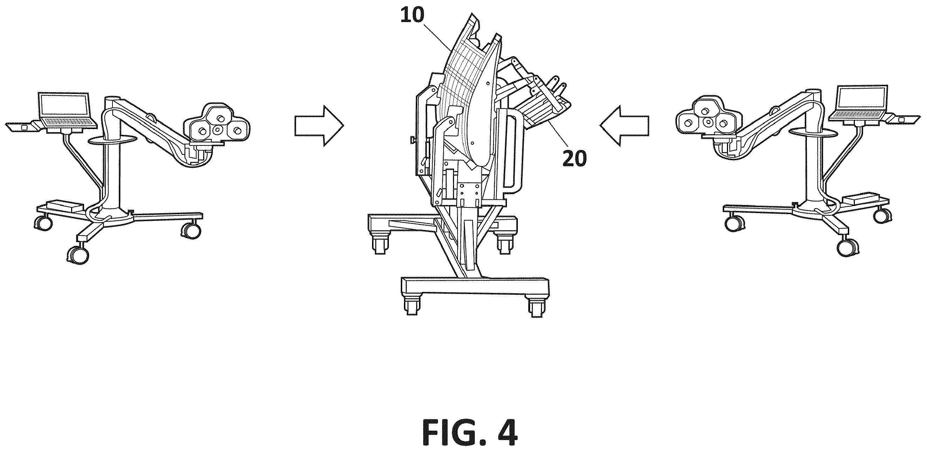

Figures 4-6 relate to the first step of the computer-implemented method, digitalization, where both the flap (10) and the flap-tap (20) are scanned independently. In the present test both photogrammetry and structural light pattern (SLP) scanners have been used to get more accuracy. In this regard, figure 3 shows another aerostructure being scanned using Structured Light Pattern (SLP).

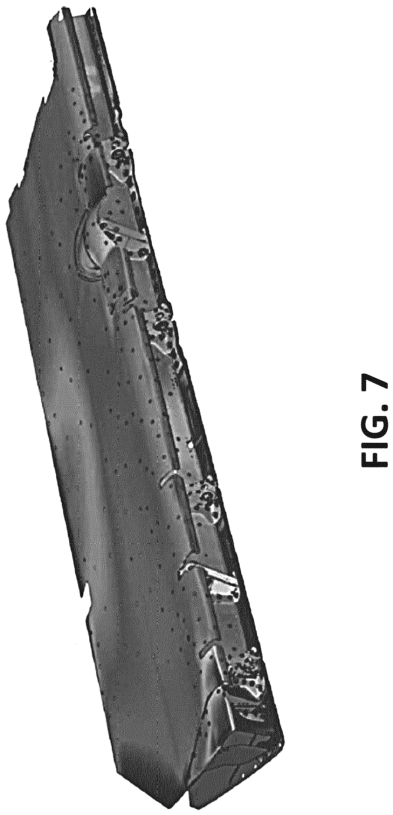

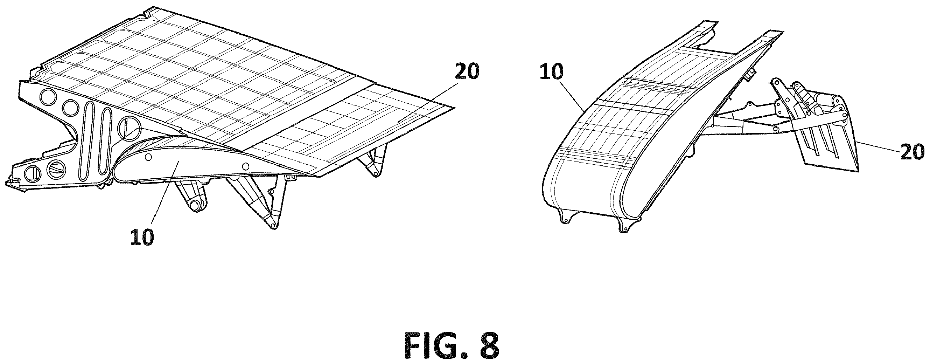

On the other hand, figures 7 and 8 relate to the second step of the computer-implemented method, creation of a digital twin model. In particular, a points cloud alignment of the aerostructure to be measured is represented in figure 7, using digital mockup (MDU). For its part, digital model of figure 8 on the left shows the flap (10) and the flap-tab (20) in the kinematic retracted position, while figure 8 on the right shows the kinematic full-deployed position of said parts (10, 20) of the aerostructure.

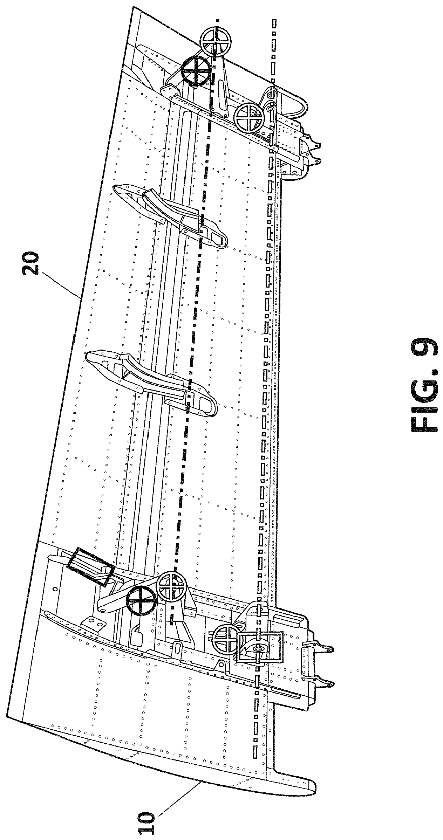

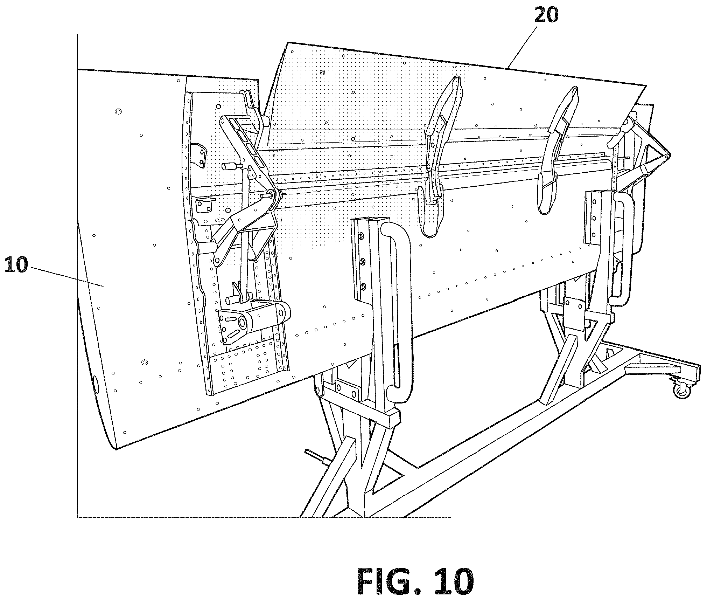

Referring now to figures 9 and 10, they relate to the third step of the computer-implemented method, virtual assembly, wherein the assembly of the flap (10) and the flap-tap (20) of the digital twin model is carried out. More specifically, figure 9 shows the virtual assembly using digital mockup (MDU) kinematic for the whole flap (10). For its part, figure 10 represents the virtual assembly of a flap-tap (20) using real kinematic measurement, that is, a virtual assembly is carried out from a real aerostructure. This is an alternative, which can be complementary and not excluding from the first alternative referring to virtual assembly using digital mockup (MDU).

Thus, by creating said digital twin model and then performing the virtual assembly of the aerostructures, it is possible to measure every detail of the parts (10, 20), every gap (G) and/or overlaps (O) between said parts (10, 20), in this example between the flap (10) and its corresponding flap-tap (20).

Finally, for the last step of the method, calculation and report, the gaps (G) and/or overlaps (O) between the flap (10) and the flap-tap (20) are measured.

Said calculation can be done at standard deflection angles, typically in some positions between completely retracted (0°) and fully deployed: 25° for flaps (10) or 30° for flap-tabs (20), see figure 8, but the computer-implemented method of the invention allows to obtain measurements in a continuous way, giving results at full kinematics and on only few discrete positions. This is in fact an additional advantage, since the fact of having generated a digital twin model allows the simulation to be carried out much more quickly, which is why it is currently only tested at certain deflection angles.

Therefore, the computer-implemented method of the invention provides a reliable and high-precision method to measure, predict and determine final measurements even at non- visible or non-measurable gaps (G) and overlaps (O) between aircraft real parts or aerostructures, even when there is a kinematic between said parts.

## Claims

1. Computer-implemented method for determining the final geometry of two or more aircraft real parts, in particular to predict final measurements even at non-visible or non-measurable gaps (G) and overlaps (O) in said aircraft real parts, and when there is a defined kinematic between them, said method comprising the following steps:
- obtaining digital data by independently scanning all the aircraft real parts which comprise gaps (G) and overlaps (O) to be measured, the digital data defining geometries and points of each aircraft real part;
- creating a digital twin model from the obtained digital data, the digital twin model comprising an aircraft digital part for each aircraft real part, the creation of each aircraft digital part of the digital twin model comprising modelling in three dimensions the defined geometries and aligning the defined points for each aircraft real part;
- performing a virtual assembly of the aircraft digital parts applying the kinematics defined for each aircraft real part to obtain at least one set of positions of the gaps (G) and overlaps (O); and
- reporting final measurements calculated for the, at least one, set of positions of the gaps (G) and overlaps (O) in the virtually assembled aircraft digital parts.

2. Computer-implemented method according to claim 1, wherein scanning the aircraft real parts is carried out using photogrammetry and structural light pattern (SLP) scanners.

3. Computer-implemented method according to claim 1, wherein aligning the points for each aircraft real part defined in the digital twin model is carried out using digital mockup (MDU) or real hinge axis of the aircraft real part.

4. Computer-implemented method according to claim 1, wherein modelling in three dimensions the defined geometries comprising placing all the geometries on a reference.

5. Computer-implemented method according to claim 1, wherein performing the virtual assembly is carried out using digital mockup (DMU) kinematics and/or real kinematics.

6. Computer-implemented method according to claim 5, further comprising, when real kinematics is used, determining the movement of the aircraft digital part by using a re-scanning of photogrammetry points of the aircraft real part in real time.

7. Computer-implemented method according to claim 6, wherein the final measurements are calculated according to measured positions of the aircraft real external parts and the calculations of distances between the measured positions of the aircraft real external parts.

8. A computer program product comprising computer-executable instructions for performing the method according to any of the claims 1-7, when the program is run on a computer.

9. A non-transitory computer readable medium encoded with a computer program comprising instructions for carrying out all the steps of the method according to any of the claims 1-7, when said computer program is executed on a computer system.
